# EUROPÄISCHE PATENTSCHRIFT

(11) **EP 4 323 229 B1**
(45) Veröffentlichungstag und Bekanntmachung des Hinweises auf die Patenterteilung: **19.02.2025**
(21) Anmeldenummer: 22708109.8
(22) Anmeldetag: 23.02.2022
(51) Int. Cl.: B60L 58/16, G01R 31/3832, G01R 31/371, H01M 10/42, G01R 31/389, B60L 58/12, B60W 20/12, G01R 31/367, H01M 10/48, H02J 7/00

(54) **ENERGIEMANAGEMENTVORRICHTUNG UND VERFAHREN ZUM BEREITSTELLEN EINES ENERGIE-SCHÄTZWERTES EINES ENERGIESPEICHERS**
ENERGY MANAGEMENT APPARATUS AND METHOD FOR PROVIDING AN ENERGY-ESTIMATION VALUE OF A BATTERY
DISPOSITIF DE GESTION D'ÉNERGIE ET PROCÉDÉ DE FOURNITURE D'UNE VALEUR D'ÉNERGIE ESTIMÉE D'UNE BATTERIE

(30) Priorität: 13.04.2021 DE 102021203610
(43) Veröffentlichungstag der Anmeldung: 21.02.2024
(73) Patentinhaber: Stellantis Auto SAS, 78300 Poissy (FR)
(72) Erfinder: POCHNER, Klaus, 65428 Rüsselsheim am Main (DE)
(74) Vertreter: PSIP
(86) Internationale Anmeldenummer: PCT/EP2022/054479
(87) Internationale Veröffentlichungsnummer: WO 2022/218594

(56) Entgegenhaltungen:
- DE-A1- 102012 214 962
- DE-A1- 102018 116 826
- DE-A1- 3 142 038
- GB-A- 2 505 663
- GB-A- 2 515 582
- US-A1- 2012 074 960
- US-A1- 2021 063 491

## Beschreibung

Die Erfindung betrifft das technische Gebiet von Transportsystemen. Insbesondere betrifft die vorliegende Erfindung eine Energiemanagementvorrichtung, ein Verfahren zum Bereitstellen eines Energie-Schätzwertes eines Energiespeichers und ein Transportmittel.

Immer neuere elektrische Energiespeichertechniken und weiterentwickelte Antriebstechniken verbunden mit reduzierten Herstellungskosten sorgen für die Entwicklung von neuen Transport- und Fortbewegungsmitteln, wie beispielsweise Hoverboards, und sorgen auch dafür, dass immer mehr herkömmliche Verkehrsmittel elektrifiziert werden, wie beispielsweise Roller oder Fahrräder.

Auch werden elektrische Energiespeicher, insbesondere wegen ihrer nachgesagten besseren Klimaverträglichkeit, vermehrt in Transportmitteln wie Autos oder LKWs eingebaut, die beispielsweise als reine Elektrofahrzeuge (electric vehicles, EV) oder batteriebetriebene Elektrofahrzeuge (BEV), als hybride Elektrofahrzeuge (hybrid electric vehicle, HEV) oder als Plugin-hybride Elektrofahrzeuge (plug-in hybrid electric vehicle, PHEV) auf dem Mark angeboten werden.

Eine große Unsicherheit besteht jedoch für einen Nutzer elektrisch betriebener Transportmittel darin, dass sich der Ladezustand des Energiespeichers und damit eine Reichweite und/oder Nutzungszeit nur schwer vorhersagen lässt.

Während leichte Fahrzeuge wie E-Fahrräder oder E-Roller im Falle einer aufgebrauchten Energiereserve meist problemlos weiterbenutzt bzw. zu einer Ladestation für den Energiespeicher transportiert werden können, stellt ein leerer Energiespeicher bei einem Auto oder LKW ein großes Problem dar. Solch ein schweres Fahrzeug lässt sich meist nur unter hohem Kostenaufwand zu einer Ladestation transportieren, wenn es liegen geblieben ist.

Daher wurden Anzeigeeinrichtungen entwickeln, die einem Nutzer des Transportmittels zumindest den Ladezustand des Energiespeichers und ggf. daraus abgeleitet eine geschätzte Reichweite anzeigen können.

Die Druckschrift DE 10 2013 002 243 A1 betrifft eine Technik zur Ausgabe eines Reichweitenhinweises für ein Fahrzeug. Ein Verfahrensaspekt hierzu umfasst ein Ermitteln eines Antriebsenergievorrats des Fahrzeugs sowie ein Berechnen einer Reichweite des Fahrzeugs basierend auf dem Antriebsenergievorrat; ein Abrufen von Verkehrsnetzinformationen, wobei die Verkehrsnetzinformationen Informationen zur Darstellung eines Verkehrsnetzes umfassen; ein Anzeigen des Verkehrsnetzes basierend auf den abgerufenen Verkehrsnetzinformationen und eine um einen Ausgangspunkt innerhalb des angezeigten Verkehrsnetzes liegende Reichweitenkennzeichnung, die die Reichweite des Fahrzeugs hervorhebt; ein Bestimmen eines Zielpunktes; ein Berechnen einer oder mehrerer Fahrtrouten zwischen dem Ausgangspunkt und dem Zielpunkt basierend auf den Verkehrsnetzinformationen; ein Ermitteln einer Restfahrtstrecke für die eine oder mehreren Fahrtrouten, wobei die Restfahrtstrecke vom Ausgangspunkt bis zu einem Endpunkt reicht, der auf der jeweiligen Fahrtroute liegt und an dem der Antriebsenergievorrat zu Ende geht, und wobei der Endpunkt basierend auf den Verkehrsnetzinformationen ermittelt wird; und ein Ausgeben eines Hinweises, wenn mindestens ein auf einer der Fahrtrouten liegender Endpunkt ermittelt wurde.

Die Druckschrift WO 2013/026070 A2 beschreibt eine Batteriemanagement-Einheit (BMU) welche mit einem Batteriepaket eines beliebigen Fahrzeugs (xEV) gekoppelt ist, das wenigstens einen Teil seiner Antriebskraft von einer elektrischen Energiequelle bezieht, wobei die BMU dazu eingerichtet ist, einen Restenergiewert für das Batteriepack zumindest teilweise basierend auf einer minimalen Zelltemperatur und einem minimalen Zellladungszustand-Prozentsatz (SOC%) zu bestimmen, welcher von der BMU für den Batteriepack bestimmt wird.

Die Druckschrift DE 10 2015 118 976 A1 betrifft ein Verfahren zum Schätzen der Reichweite pro Vollaufladung (RPC) für ein Fahrzeug. Das Verfahren beinhaltet eine Steuerung, die als Reaktion auf das Detektieren einer vordefinierten Bedingung, die den Fahrzeugenergieverbrauch beeinflusst, eine RPC und Kennzeichen, die ein Ausmaß angeben, zu dem die vordefinierte Bedingung die RPC beeinflusst, an eine Schnittstelle durch eine Steuerung ausgeben kann. Es wird ebenfalls ein elektrisch betriebenes Fahrzeug bereitgestellt, das eine oder mehrere Fahrzeugkomponenten, eine Traktionsbatterie zum Zuführen von Energie zu den Fahrzeugkomponenten, einen oder mehrere Sensoren und eine Steuerung enthält. Der eine oder die mehreren Sensoren überwachen die Fahrzeugkomponenten, die Traktionsbatterie und vorausgewählte Umgebungsbedingungen. Die Steuerung ist dazu ausgelegt, als Reaktion auf eine Eingabe von den Sensoren eine Ausgabe für eine Schnittstelle zu generieren, die eine RPC und Kennzeichen beinhaltet, die ein Ausmaß des Einflusses jeder der Umgebungsbedingungen und des Betriebs der Komponenten und der Batterie auf die RPC angeben.

Die Druckschrift DE 10 2018 116 826 A1 beschreibt ein Fahrzeug, welches einen Satz von Antriebsrädern beinhaltet und außerdem eine Energiequelle mit verfügbarer Energie, eine drehmomenterzeugende Vorrichtung, die von der Energiequelle angetrieben wird, um ein Antriebsdrehmoment bereitzustellen, ein Getriebe, das konfiguriert ist, das Antriebsdrehmoment zu empfangen und ein Abtriebsdrehmoment an den Satz von Antriebsrädern bereitzustellen, und eine Steuerung. Die Steuerung sagt als Teil eines programmierten Verfahrens den Verbrauch der verfügbaren Energie entlang einer vorbestimmten Fahrroute unter Verwendung von Onboard-Daten, Offboard-Daten und einem ersten Logikblock voraus und korrigiert auch den vorhergesagten Energieverbrauch unter Verwendung der Onboard-Daten, Offboard-Daten und einer Fehlerkorrekturschleife zwischen einem zweiten Logikblock und dem ersten Logikblock. Die Steuerung führt unter Verwendung des korrigierten Energieverbrauchs ebenfalls eine Steuermaßnahme in Bezug auf das Fahrzeug aus, einschließlich des Änderns eines Logikzustands des Fahrzeugs.

Die US 2021/0063491 A1 betrifft ein Verfahren zur Schätzung der Restenergie einer Batterie, wobei basierend auf einem Gesundheitszustand (SOH) der Batterie, einer Zelltemperatur und einem Batteriestrom ein korrigierter Ladezustand (SOC) sowie ein Energiezustands (SOE) der Batterie ermittelt wird. Die Restenergie ergibt sich aus dem Energiezustands und einer gesamten entladbaren Energie der Batterie, die basierend auf dem Gesundheitszustand und einer Referenzentladeenergie ermittelt wird. Die Referenzentladeenergie wird auf Basis einer konstanten Entladerate und in Abhängigkeit von der Zelltemperatur und dem Gesundheitszustand der Batterie ermittelt.

Aus der GB 2 515 582 A ist ein Verfahren zum Bestimmen einer vorhergesagten Reichweite eines Elektrofahrzeugs bekannt, das auf einem aktuellen Fahrzeugbetriebszyklus und einem Reichweitenmodell beruht. Dieses Reichweitenmodell hängt von einem Energieverbrauchsratenwert ab, der während eines vorherigen Fahrzeugbetriebszyklus aufgezeichnet wurde, und erlaubt es, aktuellen Energiegradientenwert zu ermitteln.

Ferner betrifft die DE 10 2018 116826 A1 ein Verfahren, das eine Vorhersage des Energieverbrauchs und einer geschätzten elektrischen Reichweite eines Fahrzeugs unter Verwendung von Offboard- und Onboard-Daten ermöglicht.

DE 10 2012 214962 A1 offenbart Energiemanagementvorrichtung für Energiespeicher,aufweisend Energiespeicher, Energiespeicher-Verwaltungseinrichtung, Energieschätzeinrichtung und Reichweiten-schätzeinrichtung; wobei die Reichweiten-schätzeinrichtung eingerichtet ist, den Energieschätzwert in eine Schätz-Reichweite umzuwandeln.

Aufgabe der vorliegenden Erfindung ist es ein effizientes Energiemanagement für einen Energiespeicher zu schaffen.

Die Erfindung ergibt sich aus den Merkmalen der unabhängigen Ansprüche. Vorteilhafte Weiterbildungen und Ausgestaltungen sind Gegenstand der abhängigen Ansprüche. Weitere Merkmale, Anwendungsmöglichkeiten und Vorteile der Erfindung ergeben sich aus der nachfolgenden Beschreibung, sowie der Erläuterung von Ausführungsbeispielen der Erfindung, die in den Figuren dargestellt sind.

Gemäß einem Aspekt der vorliegenden Erfindung wird eine Energiemanagementvorrichtung für einen Energiespeicher bereitgestellt, welche einen Energiespeicher, eine Energiespeicher-Verwaltungseinrichtung und eine Energieschätzeinrichtung sowie eine Reichweitenschätzeinrichtung aufweist. Die Energiespeicher-Verwaltungseinrichtung oder das Batteriemanagementsystem (BMS) ist zum Erfassen und Bereitstellen von einer Vielzahl in dem Energiespeicher vorhandenen Energiespeicher-Parametern eingerichtet.

Die Energieschätzeinrichtung ist zum Empfangen der Vielzahl von Energiespeicher-Parameter und zum Bereitstellen eines Energie-Schätzwertes aus der Vielzahl von Energiespeicher-Parametern eingerichtet.

Die Energieschätzeinrichtung aus der bereitgestellten Vielzahl von Energiespeicher-Parametern im Wesentlichen nur Strom-Parameter auswählt, wobei ein Strom-Parameter ein Parameter ist, der auf den Stromfluss in und/oder aus dem Energiespeicher einen Einfluss hat.

Die Energiemanagementvorrichtung weist eine Reichweitenschätzeinrichtung (range estimator) auf, wobei die Reichweitenschätzeinrichtung eingerichtet ist, den Energie-Schätzwert in eine Schätz-Reichweite umzuwandeln, wobei die Reichweitenschätzeinrichtung zum Umwandeln des Energie-Schätzwertes in die Reichweite eine Energie-Reichweiten-Kurve nutzt, welche in Strom-Parametern dargestellt ist.

Die Energie-Reichweiten-Kurve weist einen ersten und einen zweiten Kurvenabschnitt auf. Der erste Kurvenabschnitt ist dabei so an den zweiten Kurvenabschnitt angepasst, dass die Energie-Reichweiten-Kurve eine stetige Kurve bildet.

Der zweite Kurvenabschnitt der Energie-Reichweiten-Kurve, welcher im Bereich einer niedrigen vorhandenen Energie im Energiespeicher liegt, ist mit einer höheren Genauigkeit ermittelt worden, als der erste Kurvenabschnitt der Energie-Reichweiten-Kurve, welcher im Bereich einer hohen vorhandenen Energie im Energiespeicher liegt.

Der Energie-Schätzwert ist ein Energie-Zustandswert (State of Energy, SoE), der eine Aussage über den Energieinhalt des Energiespeichers, der Batterie und/oder des Akkus erlaubt.

Über die Strom-Parameter kann eine sehr genaue Aussage über die Ladung und/oder den Lade-Zustandswert (SoC) des Energiespeichers getroffen werden.

Der Energieinhalt eines Energiespeichers, insbesondere eines Akkus und/oder einer Batterie, ist nur sehr schwer direkt messbar. Er wird daher oft durch indirekte Größen, die mittels einer Formel verknüpft sind, berechnet. Die elektrische Energie einer Batterie mag im Wesentlichen über die physikalischen Größen Strom I und Spannung U berechenbar sein.

Um eine Aussage über den Ladezustand der Batterie zu machen, muss somit ständig Strom und Spannung gemessen werden. Hierbei mögen im Wesentlichen Momentan-Messwerte genutzt werden. Jedoch ist die Spannung eine sehr ungenaue Größe, die beispielsweise unter Last einbrechen mag. Für eine genaue Messung müsste somit vor der Messung die Last von der Batterie getrennt werden.

Der Energie-Schätzwert ist jedoch interessant, da eine Reichweitenangabe für ein Transportmittel, beispielsweise ein Kraftfahrzeug oder einen LKW, getroffen werden kann, wenn für das Fahrzeug typische Verbrauchswerte angegeben sind, die beispielsweise in kWh/100km angegeben werden. Die Vorhersagen mögen sich noch verfeinern lassen, wenn die Topologie der Fahrstrecke und der der jeweiligen Topologie zugeordnete Verbrauchswert berücksichtigt werden kann, beispielsweise ob das zu erreichende Fahrziel über eine bergige und/oder gerade Fläche führt.

Vorteilhafterweise ist der Strom-Parameter zumindest ein Energiespeicher-Parameter, ausgewählt aus der Gruppe der Energiespeicher-Parameter, bestehend aus einem Strombilanzwert, einem elektrischen Widerstand des Energiespeichers, einer Momentan-Spannung am Energiespeicher, einem Momentan-Strom am Energiespeicher, einer Energiespeicher-Temperatur, einem Alter des Energiespeichers und einer Inter-Zellspannungsdifferenz einzelner Zellen des Energiespeichers, insbesondere wenn der Energiespeicher als ein Energiespeicher-Pack oder Energiespeicher-Paket ausgebildet ist.

Mittels des Strombilanzwertes mag sich die Ladungsmenge einer Batterie mit einer hohen Genauigkeit bestimmen lassen, wenn einige Randbedingungen beachtet werden. Denn Ladung an sich mag nur in einem sehr geringen Maß in Form eines Leckstroms verschwinden. Insbesondere bei einer kurzen Standzeit des Transportmittels, mag ein Leckstrom kaum ins Gewicht fallen. Daher kann bei Kenntnis des Ladungszustands und des Zu- bzw. Abflusses von Ladung sehr genau bilanzierbar sein, welche Ladung in dem Energiespeicher vorhanden ist.

Da Ladung im Wesentlichen nur in Form eines Stromes verschwinden kann, mag es vorteilhaft sein, Stromparameter zur Energie zur Ermittlung des Energie-Schätzwertes heranzuziehen.

Physikalisch mag die Strombilanz durch das Bilden der Divergenz des Stromflusses durch eine virtuell den Energiespeicher umgebende Fläche beschreibbar sein, ausgedrückt durch div () und/oder ∮ x*.*

Es mag möglich sein die Reichweite eines, mit einer Batterie betriebenen, elektrischen Fahrzeugs vorherzusagen, wobei die Reichweite mit einem Algorithmus aus der verfügbaren Ladung der Batterie (State of Energy, SoE) und dem spezifischen Verbrauch in kWh/100km berechnet wird.

Durch das Bestimmen der Ladung und/oder des Stromes mag es möglich sein, die verfügbare Energie der Batterie unter Berücksichtigung einer niedrigeren Spannung einer entladenen Batterie zu korrigieren. Bei einer spannungsmäßigen Betrachtung könnte aufgrund des lastbedingten Spannungseinbruchs eine Verfälschung der Ergebnisse stattfinden. Der Einfluss der Temperatur auf den Widerstand der Batterie wird ebenfalls beachtet. In einem Beispiel mögen historische Verbrauchsdaten mit Umgebungsbedingungen wie beispielsweise Außentemperatur und Batteriekühlung kombiniert werden, um die Batterietemperatur und ihren inneren Widerstand zu berechnen.

Durch die Betrachtung der Strom-Parameter mag es auch möglich sein, existierende Energieverbrauchsmodelle zu nutzen, um einen Energie-Schätzwert zu liefern, nachdem diese Modelle auf Strom-Parameter transformiert worden sind und/oder mit Strom-Parametern ausgedrückt sind.

Indem eine Energie-Reichweiten-Kurve und/oder ein Energiemodell in Strom-Parametern dargestellt wird, mag sie/es für eine Strom Betrachtung der Reichweitenbestimmung nutzbar sein. Das Verwenden von Stromwerten mag Ungenauigkeiten aufgrund von lastbedingten Spannungseinbrüchen und die davon verursachten Messfehler im Wesentlichen vermeiden, weshalb sehr genaue Reichweitenangaben zu erwarten sind.

In anderen Worten lässt sich durch diese Vorgabe ein Schätzwert für die gespeicherte Energie beispielsweise in kWh ermitteln, der stabil ist und gegen einen sehr exakten Schätzwert konvergiert, welcher im Wesentlichen in dem kurz-vor-leer oder nahezu leer Energiebereich des Energiespeichers liegt. Die detaillierte Betrachtung des Bereichs bevor die Energie aus dem Energiespeicher im Wesentlichen aufgebraucht ist mag daher nützlich sein, da dies der kritische Bereich ist, der möglicherweise darüber entscheidet, ob mit der Restenergiemenge noch eine Ladestation erreicht werden kann. Es könnte zu einem Liegenbleiben eines von dem Energiespeicher angetriebenen Transportmittels kommen, wenn der Reserve-Bereich nicht mit einer hohen Genauigkeit dargestellt wird.

Ebenso mag auch eine möglichst stabile Vorhersage von Verbrauchswerten zu einer stabilen Rest-Reichweitenanzeige beitragen. Die Vorhersage mag von instabilen Ereignissen, wie einem Spannungseinbruch unter Last, im Wesentlichen unabhängig werden. Daher mag, sobald der zweite Kurvenabschnitt erreicht ist, eine sehr genaue Reichweitenbestimmung möglich sein. Selbst wenn solch ein instabiles Ereignis eintritt, mag dies kompensiert werden und an einem Ausgabewert im Wesentlichen nicht bemerkt werden. So mag die niedrigere Spannung einer entladenen Batterie berücksichtigt werden. Insbesondere mag der lastbasierte Spannungseinbruch einen nur geringen Einfluss auf die Strom-Parameter haben.

Darüber hinaus mag in dem zweiten Kurvenabschnitt eine Steigung der Kurve konstant gehalten werden, um einen möglichst kontinuierlichen Verlauf der Rest-Reichweite zu ermöglichen. Änderungen der Lage der Kurve mögen verhindert werden, indem darauf geachtet wird, dass sich die Lage Kurve stetig verhält. Physikalische Unzulänglichkeiten, wie ein Anstieg der Energie ohne Energiezufuhr, mögen berücksichtigt und/oder korrigiert werden. Solche Unzulänglichkeiten mögen auf schwer vorhersagbare Spannungseinbrüche unter Last zurückgehen und diese mögen korrigiert werden.

Gemäß einem anderen Aspekt der vorliegenden Erfindung hängt ein Übergang von dem ersten Kurvenabschnitt zu dem zweiten Kurvenabschnitt der Energie-Reichweiten-Kurve von zumindest einem Übergangskriterium ab, ausgewählt aus der Gruppe von Übergangskriterien, bestehend aus einer Betriebszeit, einem Ladezustand des Energiespeichers, einer Mindestdistanz zu einem Ziel und einem Trigger-Ereignis.

Die Strom-Parameter mögen zumindest teilweise nicht sofort nach dem Start bereitstehen und werden erst während der unmittelbar nach dem Start zurückgelegten Strecke ermittelt. Eine Größe wie der Ladezustand kann auch durch eine vorausgehende Fahrt beeinflusst sein. Größen, die auf eine Rest-Reichweite Einfluss haben können, wie beispielsweise ein Fahrerprofil, mögen nicht speicherbar sein und daher nicht gleich zu Beginn eines Fahrzyklus zur Verfügung stehen. Diese müssen erst während der Fahrt ermittelt werden, insbesondere wenn der Fahrer wechselt.

Es mag auch dienlich sein, wenn die Genauigkeit des bereitgestellten Energie-Schätzwertes auf Zeitbereiche erstreckt wird, in welchen eine genaue Vorhersage von hoher Bedeutung ist, beispielsweise, wenn der Energiespeicher fast leer ist und/oder ein Drittel seiner ursprünglichen Ladung erreicht hat.

Es mag auch möglich sein mittels einer Triggereinrichtung, beispielsweise einen Schalter, die Genauigkeit zu erhöhen und die Energiemanagementvorrichtung zu nutzen.

Es mag auch eine Anzeige vorhanden sein, an der abgelesen werden kann, mit welcher Genauigkeit die aktuellen Energie-Schätzwerte ermittelt werden.

In einem Beispiel mag der zweite Kurvenabschnitt einen Bereich der verbleibenden RestReichweite von 0% bis 40% der Gesamt-Reichweite umfassen. In einem anderen Beispiel mag dieser Bereich 0% bis 20% und in noch einem anderen Beispiel 0% bis 60% umfassen. Um auszudrücken, dass es sich um eine Rest-Reichweite handelt kann dem Prozentwert ein Minuszeichen vorangestellt werden. Die Darstellung der Rest-Reichweite kann aber auch in absoluten Werten erfolgen.

In einem Beispiel wird der Energie-Schätzwert einer Filterung unterzogen, um im Wesentlichen zu einem stabilen Verlauf der Kurve zu kommen.

Eine Filterung, beispielsweise mittels eines Kalman-Filters, kann aus einer Vielzahl von Messwerten einen repräsentativen Wert erzeugen, wodurch sich eine stetige Energie-Reichweiten-Kurve bilden lässt, welche stabile Werte liefern kann. Insbesondere mag dafür gesorgt werden, dass die Steigung der Kurve in Abhängigkeit von fallenden Energie-Schätzwerten konstant bleibt.

In einem Beispiel werden die ausgewählten Energiespeicher-Parameter der Energiespeicherverwaltungseinrichtung durch zumindest eine Messung des momentanen Stroms, der momentanen Spannung, der Temperatur des Energiespeichers und/oder des Innenwiderstands des Energiespeichers ermittelt.

Gemäß einem weiteren Aspekt der vorliegenden Erfindung ist die Reichweitenschätzeinrichtung eingerichtet die Temperatur des Energiespeichers und/oder den Innenwiderstand des Energiespeichers vorherzusagen.

Diese äußeren Parameter können mit Fühlern und/oder Sensoren mittels der Reichweitenschätzeinrichtung und/oder mittels der Energiespeicher-Verwaltungseinrichtung erfasst und bereitgestellt werden und in der Auswahl berücksichtigt werden. Mittels Karten- und/oder Routen-Informationen aus einem Navigationssystem mag sich auch über diese Parameter eine Vorhersage erstellen lassen. Auf diese Weise mag sich ein für den Stromfluss relevanter Parameter sehr genau ermitteln lassen.

Der Energiewert der in einem Energiespeicher vorhandenen Energie mag in kWh angegeben werden. Wenn die Energie-Reichweiten-Kurve in kWh bezogen auf die Restreichweite in km angegeben ist, d.h. in kWh/km, kann durch Bestimmung der vorhandenen Energie die RestReichweite ermittelt werden. Wenn durch die Ermittlung des Energie-Schätzwertes basierend auf Strom-Parametern ein stabiler Energie-Schätzwert angegeben werden kann, kann auch eine stabile und zuverlässige Vorhersage der Rest-Reichweite erstellt werden.

Gemäß noch einem Aspekt der vorliegenden Erfindung weist die Energiemanagementvorrichtung eine Anzeigeneinrichtung auf, wobei die Anzeigeneinrichtung zum Anzeigen des Schätz-Reichweite eingerichtet ist.

Bei der Anzeigeneinrichtung kann es sich um ein Navigationssystem und/oder einen Bordcomputer handeln. Aber auch um eine Einzelanzeige, die einen digitalen Reichweitenvorhersage-Wert und/oder eine Schätz-Reichweite darstellt.

Gemäß einem weiteren Aspekt der vorliegenden Erfindung wird ein Verfahren zum Bereitstellen eines Energie-Schätzwertes eines Energiespeichers beschrieben gemäß Anspruch 6, aufweisend das Erfassen von einer Vielzahl in dem Energiespeicher vorhandenen Energiespeicher-Parametern. Weiter weist das Verfahren das Bereitstellen der Vielzahl von erfassten in dem Energiespeicher vorhandenen Energiespeicher-Parameter auf, sowie das Empfangen der Vielzahl von Energiespeicher-Parameter, beispielsweise in einem anderen Modul einer Energiemanagementvorrichtung. Das Verfahren mag auch das Verarbeiten der Vielzahl von Energiespeicher-Parametern aufweisen, sowie das Bereitstellen eines Energie-Schätzwertes aus der Vielzahl von Energiespeicher-Parametern.

Das Verfahren sieht das Auswählen von im Wesentlichen nur Strom-Parametern aus der Vielzahl von Energiespeicher-Parametern vor, wobei ein Strom-Parameter ein Parameter ist, der auf den Stromfluss in und/oder aus dem Energiespeicher einen Einfluss hat.

Gemäß noch einem Aspekt der vorliegenden Erfindung wird ein Programmelement bereitgestellt, welches, wenn es von einem Prozessor ausgeführt wird, das Verfahren zum Bereitstellen eines Energie-Schätzwertes eines Energiespeichers ausführt.

Gemäß noch einem anderen Aspekt der vorliegenden Erfindung wird ein computerlesbares Speichermedium bereitgestellt, in dem ein Programm gespeichert ist, welches, wenn es von einem Prozessor ausgeführt wird, das Verfahren zum Bereitstellen eines Energie-Schätzwertes eines Energiespeichers ausführt.

Als ein computerlesbares Speichermedium mag eine Floppy Disc, eine Festplatte, ein USB (Universal Serial Bus) Speichergerät, ein RAM (Random Access Memory), ein ROM (Read Only Memory) oder ein EPROM (Erasable Programmable Read Only Memory) genutzt werden. Als Speichermedium kann auch ein ASIC (application-specific integrated circuit) oder ein FPGA (field-programmable gate array) genutzt werden sowie eine SSD (Solid-State-Drive) Technologie oder ein Flash-basiertes Speichermedium. Ebenso kann als Speichermedium ein Web-Server oder eine Cloud genutzt werden. Als ein computerlesbares Speichermedium mag auch ein Kommunikationsnetz angesehen werden, wie zum Beispiel das Internet, welches das Herunterladen eines Programmcodes zulassen mag. Es kann eine funkbasierte Netzwerktechnologie und/oder eine kabelgebundene Netzwerktechnologie genutzt werden.

Auch kann ein Prozessor des Bordsystems und/oder ein VCU (vehicle control unit) genutzt werden, um das Verfahren auszuführen.

Gemäß noch einem Aspekt der vorliegenden Erfindung wird ein Transportmittel bereitgestellt, welches die erfindungsgemäße Energiemanagementvorrichtung aufweist.

Ein Transportmittel kann ein Kraftfahrzeug und/oder ein LKW, ein E-Bike, ein E-Scooter und/oder ein Zug sein.

Weitere Vorteile, Merkmale und Einzelheiten ergeben sich aus der nachfolgenden Beschreibung, in der - gegebenenfalls unter Bezug auf die Zeichnung - zumindest ein Ausführungsbeispiel im Einzelnen beschrieben ist. Beschriebene und/oder bildlich dargestellte Merkmale können für sich oder in beliebiger, sinnvoller Kombination den Gegenstand der Erfindung bilden, gegebenenfalls auch unabhängig von den Ansprüchen, und können insbesondere zusätzlich auch Gegenstand einer oder mehrerer separater Anmeldung/en sein. Gleiche, ähnliche und/oder funktionsgleiche Teile sind mit gleichen Bezugszeichen versehen.

Es zeigen:
- Figur 1: eine Energiemanagementvorrichtung für einen Energiespeicher gemäß einem exemplarischen Ausführungsbeispiel der vorliegenden Erfindung.
- Figur 2: eine Energie-Reichweiten-Kurve in einem Energie-Reichweiten-Diagramm zum besseren Verständnis der vorliegenden Erfindung.
- Figur 2a: ein Spannungs-Ladezustands-Diagramm gemäß einem exemplarischen Ausführungsbeispiel der vorliegenden Erfindung.
- Figur 2b: zwei Energie-Reichweiten-Kurven in einem Energie-Reichweiten-Diagramm gemäß einem exemplarischen Ausführungsbeispiel der vorliegenden Erfindung.
- Figur 3: ein Flussdiagramm für ein Verfahren zum Bereitstellen eines Energie-Schätzwertes eines Energiespeichers gemäß einem exemplarischen Ausführungsbeispiel der vorliegenden Erfindung.

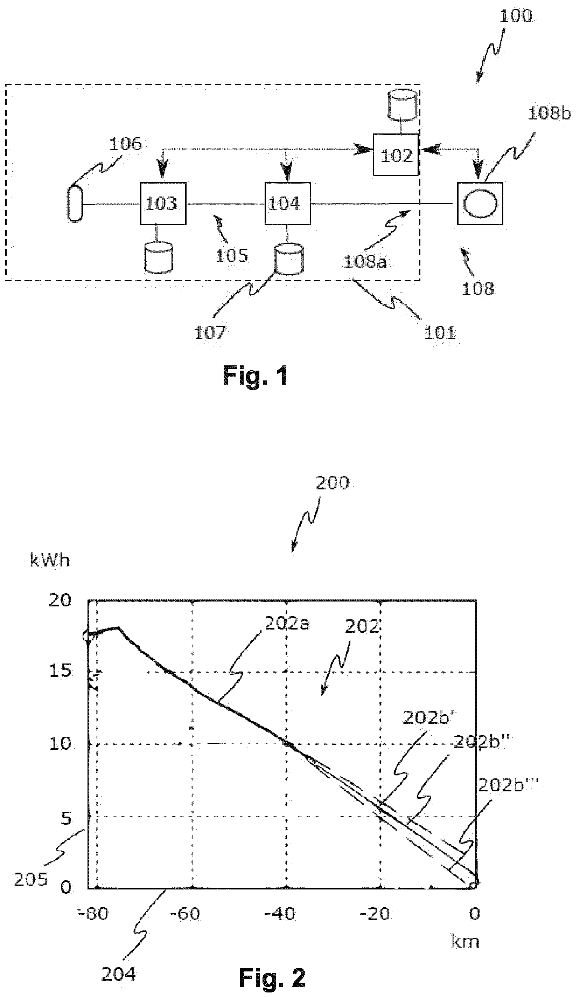

Fig. 1 zeigt eine Energiemanagementvorrichtung 100 für einen Energiespeicher 106 gemäß einem exemplarischen Ausführungsbeispiel der vorliegenden Erfindung. Außer dem Energiespeicher 106 weist die Energiemanagementvorrichtung 100 auch eine EnergiespeicherVerwaltungseinrichtung 103 oder ein Battery Management System 103 (BMS), eine Energieschätzeinrichtung 104 und eine Ausgabeeinrichtung 108b auf, welche über einer Schnittstelle 108a an der Energieschätzeinrichtung 104 angebunden ist.

Die Energiespeicherverwaltungseinrichtung 103 erfasst eine Vielzahl in dem Energiespeicher 106 vorhandenen Energiespeicher-Parameter mit entsprechenden Sensoren. Die Energieschätzeinrichtung 104 empfängt zumindest einen Teil der Vielzahl von Energiespeicher-Parameter und ermittelt aus diesen Parametern einen Energie-Schätzwert. Diesen EnergieSchätzwert stellt sie über die Schnittstelle 108a zur weiteren Verarbeitung zur Verfügung.

Die Energieschätzeinrichtung 104 wählt zur Ermittlung des Energie-Schätzwerts nur einen Teil der ihr zur Verfügung gestellten Energiespeicher-Parameter aus. Sie wählt aus der bereitgestellten Vielzahl von Energiespeicher-Parametern im Wesentlichen nur Strom-Parameter aus. Die Strom-Parameter mögen mit der Ladung des Energiespeichers in einem Zusammenhang stehen. Über die Ladung mögen sich auch Rückschlüsse über die gespeicherte Energie treffen lassen.

Ein Strom-Parameter ist ein Parameter, der auf den Stromfluss in und/oder aus dem Energiespeicher 106 einen Einfluss hat.

In einer Energiemanagementvorrichtung 100 können Energieschätzungen an mehreren Stellen durchgeführt werden. Die Energiespeicher-Verwaltungseinrichtung 103 mag in der Lage sein einen Energieschätzwert zu ermitteln. Dabei nutzt sie ein Batteriemodell. Alternativ und/oder zusätzlich mag auch die Energieschätzeinrichtung 104 in der Lage sein solche Energieschätzungen vorzunehmen. Diese nutzt ein Fahrzeugmodell zur Energieschätzung.

Die Energiemanagementvorrichtung kann in einem Modulgehäuse 101 als ein modulares Bauteil bereitgestellt werden und von dem Prozessor 102 überwacht und gesteuert werden.

An der Energiespeicher-Verwaltungseinrichtung 103 kann über die Parameterschnittstelle 105 eine Energieschätzeinrichtung 104 angeschlossen sein. Die Energieschätzeinrichtung 104 kann über die externe Energieschätzwert-Einrichtung 105a mit einer Anzeigeeinrichtung 108b verbunden sein, welche zum Ermitteln und/oder Anzeigen des Reichweitenvorhersage-Werts eingerichtet ist.

Die Anzeigeeinrichtung 108b bildet zusammen mit der Schnittstelle 108a für den Energieschätzwert die Reichweitenschätzeinrichtung 108. Diese dient der Vorhersage einer anzunehmenden Rest-Reichweite und wandelt den Energie-Schätzwert in eine Schätz-Reichweite um, beispielsweise auch indem sie einen zukünftigen Verbrauch berücksichtigt.

In einem Beispiel kann die Ermittlung des Reichweitenvorhersage-Werts oder der RestReichweite zumindest teilweise auch in der Energieschätzeinrichtung 104 durchgeführt werden, d.h. die Energieschätzeinrichtung 104 und die Reichweitenschätzeinrichtung 108 können sich gegenseitig unterstützen.

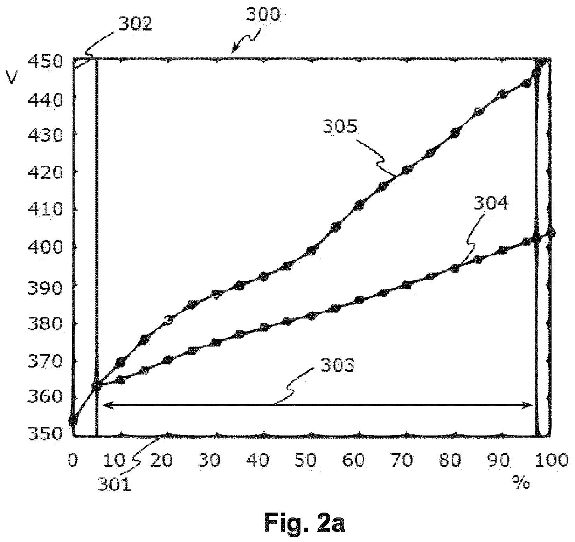

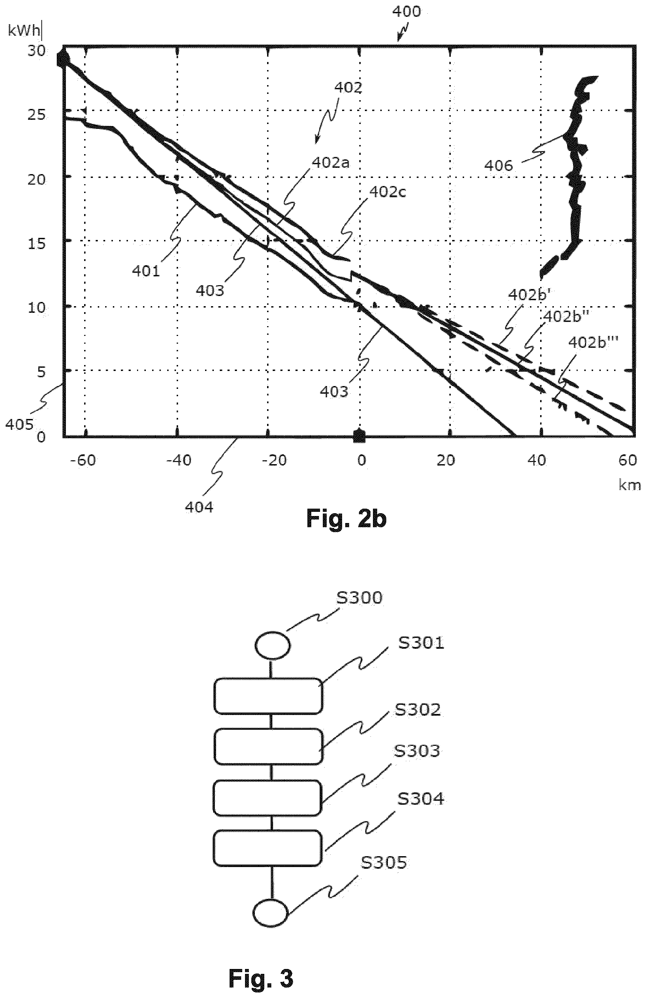

Fig. 2 zeigt eine Energie-Reichweiten-Kurve 202 in einem Energie-Reichweiten-Diagramm 200 zum besseren Verständnis der vorliegenden Erfindung.

In dem Diagramm sind auf der Abszisse 204 die Rest-Reichweite im Bereich -80 km bis 0 km eingetragen. Auf der Ordinate 205 sind Energiewerte im Bereich von 0 kWh bis 20 kWh eingetragen.

Die Energiespeicher-Verwaltungseinrichtung 103 ist mit mehreren Sensoren ausgestattet, um eine Vielzahl an Parameter des Energiespeichers zu ermitteln. Durch entsprechende Schalter und/oder Verbindungen zu den Sensoren mag die Energieschätzeinrichtung 104 auswählen, welche Parameter der Vielzahl an bereitgestellten Parameter von ihr genutzt wird. Hierbei trifft sie die Auswahl im Wesentlichen nur Strom-Parameter für die EnergieSchätzwert Ermittlung zu nutzen und Nicht-Strom Parameter im Wesentlichen zu blockieren. Auf diese Art und Weise mag eine Energieabschätzung durch eine Ladungsbetrachtung durchführbar sein.

Durch Verwendung der Strom-Parameter die mit der Ladung in Verbindung stehen, mag die Lehre genutzt werden, dass die Ladungsmenge, insbesondere der SoC (State of Charge), der ein Ausdruck der Lademenge an der Gesamt-Lademenge in Prozent ist, bei einer Batterie, beispielsweise einer Lithium-Ionen Batterie, im Wesentlichen nicht verloren gehen kann.

Diese Erkenntnis mag sich somit nutzen lassen, um mit Hilfe der Strom-Parameter eine modellierte Energie-Reichweiten-Kurve 202 so anzupassen, dass ein stabiler Verlauf entsteht. Ein stabiler Verlauf mag sich in einem Beispiel dadurch auszeichnen, dass der Kurvenverlauf in einem vorgebbaren Zeitbereich im Wesentlichen unverändert bleibt.

Die Energie-Reichweiten-Kurve 202 der Fig. 2 wurde nicht basierend auf Strom-Parameter entwickelt. Sie weist am Beginn des Fahrzyklus, bei hohen Energiewerten einen Anstieg der Energie auf und hat somit einen unstetigen Verlauf, da aufgrund der Ladungsabnahme eigentlich nur eine stetige Abnahme erfolgen kann.

Die Verwendung der Strom-Parameter und die Erkenntnis, dass die Energie stetig abnehmen mag, kann dafür sorgen, dass die Kurve im Gegensatz zur mittels Nicht-Strom-Parametern modellierten Energie im Wesentlichen stets stetig ist.

Um von den Strom-Parametern auf einen SoC ohne Vorkenntnis des Ladungszustands zu kommen, kann neben einem Lookup-Table, der zur Energieschätzung genutzt wird und beispielsweise ein Einbrechen der Spannung bei hoher Belastung berücksichtigt, ein weiterer Lookup-Table aus der Zellspannung ermittelt werden, wobei berücksichtigt werden muss, dass sich die Spannung abhängig von anderen Einflussfaktoren trotz gleichem SoC ändern kann. Solch ein Lookup-Table mag in der Datenbank 107 gespeichert sein. In der Datenbank 107 mag somit ein Lookup-Table gespeichert sein, der die Spannung als Funktion der Last angibt und/oder ein Lookup-Table der die Abhängigkeit der Spannung als Funktion eines anderen Einflussfaktors angibt.

In einem anderen Beispiel, in dem ein bekannter Ausgangswert des Ladezustands des Energiespeichers vorliegt, beispielsweise aus dem Speicher 207 vom vorherigen Fahrzyklus oder nach einer definierten Aufladung, kann der Wert des Ladungszustands inkrementell durch Ladungsbilanzierung ermittelt werden, indem die Strom-Parameter betrachtet werden.

Wenn sodann die Ladung über die Stromparameter bestimmt ist, kann die Ladung in eine Energie konvertiert, transformiert und/oder umgerechnet werden. Die so gewonnenen Energiewerte mögen stabil und sehr zuverlässig sein und so mag sich beispielsweise die Energie-Reichweiten-Kurve 202 nutzen lassen, um die Reichweitenschätzung durchzuführen

Da die Reichweitenvorhersage im Bereich eines geringen Ladungszustands und/oder einer geringen Rest-Reichweite von Bedeutung ist, mag sich die exakte Reichweitenbestimmung erst in einem späteren Zeitpunkt zuschalten lassen.

So zeigt die Energie-Reichweiten-Kurve 202 die zwei Kurvenabschnitte 202a, 202b. In dem ersten Bereich, 202a, in dem noch ein ausreichender Energievorrat vorhanden ist, mag eine Berechnung der genauen Reichweite nicht so relevant sein, wie in dem zweiten Bereich 202b. In dem ersten Bereich 202a weist die Modellierung in dem Energie-Reichweiten-Diagramm ohne hin eine Unstetigkeit und ein im Wesentlichen unrealistisches Verhalten auf. Hier mag eine exakte Berechnung der Restreichweite verzichtbar sein, während im weiteren Bereich eine solche präzise Reichweiten-Berechnung erwünscht ist, da es um die Entscheidung geht, ob ein Ziel erreicht werden kann oder nicht.

Der zweite Bereich 202b ist durch das Ausbilden einer Vielzahl von Kurven 202b', 202b", 202b‴ gekennzeichnet. Dort wird eine Reichweitenvorhersage-Berechnung für verschiedene Szenarien durchgeführt, um beispielsweise dem Fahrer unterschiedliche Verhaltensweisen vorzugeben.

Die Kurve 202b'' zeigt die Schätz-Reichweite durch eine Extrapolation unter der Bedingung, dass die Fahrt mit bisherigen Verhältnissen fortgeführt wird, beispielsweise das gleiche Fahrverhalten.

Die Maximal-Reichweiten-Kurve 202b' zeigt die Schätz-Reichweite für den Fall an, dass mit 10km/h verlangsamter Geschwindigkeit weitergefahren wird und die Minimal-Reichweiten-Kurve 202b‴ zeigt die Schätz-Reichweite für den Fall an, dass mit 10km/h erhöhter Geschwindigkeit weitergefahren wird.

In anderen Worten wird in dem Diagramm 200 dargestellt, dass wenn die Energie auf der y-Achse 205 im Verlaufe der Fahrt abnimmt und die Extrapolation ihrer gemittelten Steigung angezeigt durch die Vorhersagekurven 202b', 202b", 202b‴ die Null kWh bei einem Wert auf der Ordinate von y=0kWh nicht früher schneidet als die Null Kilometer bei einem Abszissenwert von x=0 km, dann ist die Reichweite ausreichend. Das Bild des Diagramms 200 kann auch als Ergebnis der Reichweiten-Vorhersage auf der Ausgabeeinrichtung 108b oder Anzeigeeinrichtung 108b dargestellt werden, wobei die Verwendung der Stromparameter dafür sorgt, dass der Verlauf stabil ist und dass Unstetigkeitsstellen wie in Fig. 2 bei hoher Energie und langer Reichweite vermieden werden.

Ein solcher stabiler Verlauf ist in Fig. 2 jedoch nicht dargestellt.

Um Unstetigkeitsstellen, wie in Fig. 2 im Bereich hoher Energiewerte und weitreichender Rest-Reichweiten vermeiden zu können, kann die genaue Energieberechnung erst später zugeschaltet werden und am Anfang nur mit einem Lookup-Table mit nur kleinen Korrekturen gearbeitet werden.

Das Zuschalten der genaueren Berechnung mittels Strom-Parameter mag durch ein Übergangskriterium ausgelöst werden, beispielsweise durch eine Betriebszeit, durch einen Ladezustand des Energiespeichers 106, durch eine Mindestdistanz zu einem Ziel; und/oder durch ein Trigger-Ereignis.

Beispielsweise mag es einen längeren Zeitraum benötigen, bis die Parameter stabil zur Verfügung stehen, welche eine möglichst genaue Umrechnung der Ladungsmenge in Energie zulassen und im Wesentlichen vom Strom unabhängig sind. Der Strom selbst ist ein Messwert, welcher in regelmäßigen Abständen gemessen wird und so werden auch die Parameter, welche direkt mit dem gemessenen Strom in Verbindung stehen ständig gemessen und bereitgestellt.

Parameter, welche nicht unmittelbar aus einer Strommessung gewonnen werden, sind beispielsweise aus dem Fahrerprofil und/oder Streckenprofil ermittelbar. Solche Parameter können beispielsweise in der Weise ermittelt werden, dass der künftig zu erwartende Strom aus dem Fahrerprofil und/oder Streckenprofil ermittelt wird, woraus sich dann auch die sich künftig einstellende Batterie-Zelltemperatur und der ohmsche Widerstand der Speicherbatterie 106 unter der künftig zu erwartenden Last vorhersagen lässt. In anderen Worten findet auch eine Umwandlung von Nicht-Strom Parametern auf Strom-Kenngrößen statt, um die zu erwartende Last der Batterie und die für die Lastentnahme entscheidenden Parameter möglichst genau vorhersagen zu können.

Der längere Zeitraum, bis die Parameter zur Verfügung stehen, mag sich beispielsweise derart ergeben, dass erst eine Strecke zwischen 10 km und 20 km zurückgelegt werden muss, bis sich die genauer arbeitende Reichweiten-Schätzung in der Energiemanagementvorrichtung 100 mittels Strom-Parameter zuschaltet. Eine längere Zeit mag beispielsweise vergehen bis ein Fahrerprofil ermittelt worden ist.

Durch die Energiemanagementvorrichtung 100 können verschiedene bereitgestellte Modellierungen von Energie-Reichweiten-Diagrammen 200 in einen Strom-Parameter-Raum konvertiert werden und mit Hilfe der Strom-Parameter für stabile und zuverlässige Reichweiten-Vorhersagen und/oder für das Bereitstellen von sehr genauen Schätz-Reichweiten 202b', 202b", 202b‴ sorgen.

Um zwischen dem SoE-Diagramm 200 und einem SoC-Diagramm (nicht gezeigt in Fig. 2) konvertieren zu können, mag eine im Verlauf immer steiler werdende Transformationskurve genutzt werden, die berücksichtigt, dass bei voller Batterie und hoher Spannung eine Ladungseinheit einer größeren Energie entspricht, als bei niedriger Spannung.

So eine Transformationskurve hat jedoch bei verschiedenen Temperaturen und Entladeströmen unterschiedliche Formen, so dass sich eine von Temperatur und/oder Entladestrom abhängige Transformationskurven-Schar ergibt. Mittels der Transformationskurve mag sich jedoch eine Energie-Reichweiten-Kurve 202 auch mittels Strom-Parameter nutzen lassen und für stabile Ergebnisse einsetzen lassen, da die Abhängigkeit der Energieermittlung von der entnommenen Leistung aufgehoben wird.

Beispielsweise können die aus dem Fahrerprofil und/oder Streckenprofil ermittelten Parameter genutzt werden, um eine sich künftig einstellende Batterie-Zelltemperatur und einen sich künftig einstellenden ohmschen Widerstand der Speicherbatterie 106 unter der künftig zu erwartenden Last vorherzusagen.

In einem weiteren Beispiel werden statt künftiger Werte der Momentan-Strom- und/oder Momentan-Innenwiderstands- Messwerte der Vielzahl von bereitgestellten Energiespeicher-Parametern genutzt, um einen Korrekturwert zu berechnen, der die Transformation zwischen SoE-Diagramm 200 und SoC-Diagramm ermöglicht und nicht auf eine Transformationskurve angewiesen ist.

Bei der Reichweitenberechnung mögen sich die Strom- und Temperatureffekte der Energieschätzung herauskürzen, da die Reichweitenberechnung den gemittelten Verbrauch aus der unmittelbaren Vergangenheit verwendet und somit bei der Reichweitenberechnung und Energieschätzung im Wesentlichen die gleichen oder zumindest ähnliche Korrekturen durch den Einsatz der Strom-Parameter durchgeführt werden.

Insbesondere im Bereich niedriger Energiewerte und/oder kleiner Rest-Reichweiten Werte, d.h. wenn der Energiespeicher fast leer ist, sind Korrekturen an dem SoE-Diagramm 200 mittels Strom-Parameter nötig, um auf stabile Werte für die Rest-Reichweite zu kommen und um die niedrigen Spannungen der Batterien zu kompensieren.

In anderen Worten mag vorgesehen sein, sowohl die Energie als auch einen zukünftigen Verbrauch basierend auf Strom-Parameter zu bestimmen. Somit mag im Wesentlichen die Energieschätzung als auch die Reichweitenschätzung mit reinen Strom-Parametern durchgeführt werden.

Um die Bereiche zu bestimmen, in denen die Strom-Parameter basierte Reichweitenmessung zugeschaltet werden kann, sei nochmals auf Fig. 2 verwiesen. Der erste Kurvenabschnitt 202a der Energie-Reichweiten-Kurve 202 reicht von den Rest-Reichweiten Werten von etwa -80km bis -42km auf der Abszisse 204 und von Energiewerten von 17,5kWh bis etwa 10kWh auf der Ordinate 205.

Die drei zweiten Kurvenabschnitte 202b mögen folgende Eigenschaften haben.

Die Maximal-Reichweiten-Kurve 202b' der Energie-Reichweiten-Kurve- 202, reicht von den Reichweite Werten von etwa -40km bis 0km auf der Abszisse 204 und von Energiewerten von 10kWh bis 2kWh auf der Ordinate 205. Es ist also am Ziel noch reichlich Energie vorhanden.

Die Reichweitenvorhersage-Kurve 202b" der Energie-Reichweite-Kurve- 202, reicht von den Reichweite Werten von etwa -40km bis 0km auf der Abszisse 204 und von Energiewerten von 10kWh bis 1kWh auf der Ordinate 205. Es ist also am Ziel noch etwas Energie vorhanden.

Die Minimal-Reichweiten-Kurve 202b‴ der der Energie-Reichweiten-Kurve- 202, reicht von den Reichweite Werten von etwa -40km bis 0km auf der Abszisse 204 und von Energiewerten von 10kWh bis 0kWh auf der Ordinate 205. Das Ziel kann somit gerade erreicht werden.

Als Energiespeicher 106 kann ohne Beschränkung der Allgemeinheit ein elektrischer Energiespeicher 106, insbesondere eine Batterie und/oder Akku betrachtet werden. Ein elektrischer Energiespeicher 106 kann beispielsweise als Antriebs-, HV- (High Voltage) oder Traktionsbatterie in einem BEV (Battery Electrical Vehicle) genutzt werden und speichert elektrische Energie als elektrische Ladung. Die gespeicherte elektrische Energie kann in Ampere Stunden (Ah) oder Coulomb (C) gemessen werden. Eine Traktionsbatterie 106 kann in einem Beispiel als Lithium-Ionen Batterie ausgeführt sein.

Betrachtet man das Entladeverhalten einer Traktionsbatterie 106 so lässt sich feststellen, dass, über einen kurzen Zeitraum betrachtet, im Wesentlichen der in die Nutzung des BEV gesteckte Anteil zur Entladung der Traktionsbatterie beiträgt, insbesondere der in den Antrieb gesteckte Anteil. Die Selbstentladung kann in solch einer Kurzzeitbetrachtung im Wesentlichen vernachlässigt werden. Sie findet in einem Zeitraum von Monaten statt und hat daher im Wesentlichen keinen Einfluss auf einen Fahrzyklus, d.h. auf die Reichweitenbestimmung eines BEV.

Der größte Anteil, der damit auf die Reichweite eines BEV einen Einfluss hat, ist daher die verfügbare Energie des Energiespeichers 106, welche wiederum von der Batteriespannung abhängt. Die Batteriespannung wiederum wird im Wesentlichen von dem momentan der Batterie 106 entnommenen Momentan-Strom und dem Innenwiderstand der Batterie bestimmt.

Die Energieentnahme wird von dem Batteriemanagement (BMS) 103 oder der Energiespeicher-Verwaltungseinrichtung 103 überwacht. Dieses schaltet beispielsweise die Energieentnahme einer Batterie ab, um beispielsweise die Batterie vor Tiefentladung zu schützen. Ein BMS 103 mag Teil eines gesamten Plattformkonzepts sein.

Für Nutzer eines BEVs 103 sollen möglichst die technischen Details über Ladung und Entladung einer Batterie 106 verborgen bleiben. Den Fahrer eines BEVs interessiert im Wesentlichen, wie weit die Ladung und/oder der Energievorrat seiner Batterie reicht und wann der nächste Stopp für eine Aufladung eingeplant werden muss. Dabei dient ihm im Wesentlichen eine Anzeigeeinrichtung 108b, die ihm die Reichweite der Restladung anzeigt, beispielsweise durch eine Diagrammdarstellung 200. Würde ihm lediglich eine Ladezustandsanzeige dargeboten werden, müsste sich der Fahrer während der Fahrt damit auseinandersetzen, welche weiteren Einflussfaktoren die Reichweite seines Fahrzeugs noch beeinflussen könnten. Insbesondere müsste er wissen, welche Strom-Parameter für eine präzise Anzeige von Bedeutung sind.

Eine Reichweitenschätzeinrichtung 108 übernimmt das Zusammenführen sämtlicher Reichweite relevanter Information und das Darbieten eines Reichweitenwertes 202b', 202b", 202b‴. Die Reichweitenschätzeinrichtung 108 erhält ihre Werte und Parameter unter anderem auch von der Energiespeicher-Verwaltungseinrichtung 103. Es ist gewünscht, dass die Reichweitenschätzeinrichtung 108 möglichst stabile Anzeigewerte liefert, da instabile und insbesondere sich sprunghaft ändernde Werte dazu führen könnten, dass die Reichweiten von dem Fahrer falsch eingeschätzt werden.

Eine stabile Anzeige der Reichweite mag beispielsweise dadurch erreicht werden, dass von der Vielzahl von der Energiespeicher-Verwaltungseinrichtung 103 bereitgestellten Parametern und/oder Messwerten, eine Auswahl von Parameter, die den Strom betreffen genutzt werden. Dabei ist darauf zu achten, dass die Parameter selbst möglichst stabil sind und keinen Schwankungen unterworfen sind. Schwankungen können beispielsweise dadurch entstehen, dass die Stromentnahme einer Batterie 106 während des Fahrzyklus durch starke Beschleunigungen und/oder Rekuperation stark schwankt. Solange Strom-Parameter benutzt werden können diese Schwankungen durch eine Strom- und/oder Ladungsbilanzierung erfasst werden.

Werden jedoch Spannungen zur Energiebestimmung genutzt, könnten solche Stromschwankungen zu einer Belastung der Batterieführen und die Spannung einbrechen lassen. In anderen Worten mag die richtige Auswahl eines geeigneten Parametersets aus der Vielzahl bereitgestellter Parameter ein gutes, stabiles, stetiges und zuverlässiges Vorhersagemodell ermöglichen. Da der momentan der Batterie 106 entnommene Strom bei der Ermittlung der SoE-Werte eine Rolle spielt, würden schwankende Stromwerte zu schwankenden SoE Werten führen. Bei einer Strombetrachtung und der Ermittlung des SoC können solche Schwankungen im Wesentlichen ausgeschlossen werden.

Eine stabile Anzeige einer Rest-Reichweite, die bei Anzeige eines Wertes nicht häufig ihren Wert ändert und die im Falle einer Anzeige der Rest-Reichweite als Diagramm ihre Lage und/oder Steigung im Wesentlichen unverändert hält, mag zu einem hohen Vertrauen bei einem Fahrer des Transportmittels führen.

Ebenso mag eine stetige und im Wesentlichen sich nicht sprunghaft ändernde Reichweiten Anzeige zu einem Vertrauen beim Nutzer führen.

Daher ist das in Fig. 1 dargestellte BMS 103 oder die Energiespeicher-Verwaltungseinrichtung 103 so ausgelegt, dass sie eine stabile Einschätzung der in der Batterie 106 vorhandenen Energie liefert, indem sie im Wesentlichen auf Strom-Parameter zurückgreift, welche durch eine Strom- und/oder Ladungsbilanzierung gut erfassbar sind und nicht gestört oder beeinflusst werden, beispielsweise von der Belastung der Batterie 106.

Die nicht auf lediglich Strom-Parameter vertrauende Energie-Reichweiten-Kurve 202 sieht komplizierte Modellierungen für die Reichweitenschätzung vor, um einen Ausgleich für beispielsweise eine einbrechende Spannung bei hoher Last durchführen zu können. Trotz dieser komplexen Mechanismen gelingt es ihr jedoch nicht, für einen vollständig stabilen Verlauf zu sorgen. Insbesondere im Bereich des Beginns eines Fahrzyklus und/oder bei einem hohen Energieinhalt zeigt die Energie-Reichweiten-Kurve 202 einen unstetigen und unphysikalischen Verlauf, der trotz einer Energieentnahme zu einem Anstieg der Energie führt.

Auch kann die Batterie-Zelltemperatur zu Beginn eines Fahrzyklus von den Bedingungen während der Abstellphase oder einem Soak dominiert sein. Daher mag die stabilisierte Temperatur während der Leistungsentnahme für die Abschätzung der nutzbaren Energie gegenüber der Batterie-Zelltemperatur zu Beginn eines Fahrzyklus relevanter und somit zu bevorzugen sein. Hilfsweise oder alternativ wird daher zu Beginn eines Fahrzyklus nicht die Ladungsmenge herangezogen, die bei der vorhergehenden Fahrt gespeichert wurde, sondern auch die zu diesem Zeitpunkt, also auch während einer Leistungsentnahme, herrschenden Temperaturverhältnisse in der Batterie. Auf diese während einer Leistungsentnahme, herrschenden Temperaturverhältnisse in der Batterie hat die Umgebungstemperatur einen schwachen und die Stromstärke einen starken Einfluss.

Während bei einer vollen Ladung die exakte Reichweite des BEVs noch eine untergeordnete Rolle spielt, mag die Reichweite relevant werden, wenn sich die SoE-Werte dem Bereich um -20km bis 0km nähern, da in diesem Bereich einer nahezu leeren Batterie die Reichweite entscheidend sein kann, insbesondere bei der Frage, ob mit dem Restenergieinhalt der Batterie 106 das Ziel und/oder eine entfernte Ladestation noch erreicht werden kann. Daher ist eine genaue Berechnung insbesondere in diesem Bereich erwünscht. Bis der Bereich einer nahezu leeren Batterie erreicht wird, mögen jedoch die Werte aus dem neuen Fahrtzyklus und/oder eine auf diesen Werten beruhende Vorhersage vorhanden sein

Die Fig. 2a zeigt ein Spannungs-Ladezustands-Diagramm 300 gemäß einem exemplarischen Ausführungsbeispiel der vorliegenden Erfindung.

Das Spannungs-Ladezustands-Diagramm 300 zeigt an der Abszisse 301 SOC Werte von 0%, entsprechend einer physikalisch vollständig entladenen Batterie, bis 100%, entsprechend einer physikalisch vollständig geladenen Batterie. An der Ordinate 302 sind Spannungswerte von 350 V bis 450 V angetragen.

In das Spannungs-Ladezustands - Diagramm 300 sind zwei Batterie-Spannungs-SOC Kurven 304, 305 eingezeichnet, nämlich die Effektiv-Spannungs-Kurve 304 und die Momentan-Spannungs-Kurve 305.

Die Momentan-Spannungs-Kurve 305 entspricht der zu jedem Zeitpunkt tatsächlich zu messenden Spannung, wobei bereits vorteilhafterweise anstelle der üblichen Leerlaufspannung, d.h. die Spannung bei Stromfluss Null, die Spannung aufgetragen wird, die bei der Entnahme eines typischen während der Fahrt zu erwartenden Stroms oder eines vorhergesagten Stroms herrscht. Multipliziert man die derzeit vorhandene Ladungsmenge mit der Momentan-Spannung beim derzeitigen SoC, so würde die aus der Batterie entnehmbare Energie allerdings überschätzt, da bei niedrigerem Ladungszustand auch eine niedrigere Spannung an der Batterie anliegen wird.

Diese Überschätzung mag durch die Verwendung der Effektiv-Spannungs-Kurve 304 im Wesentlichen vermeiden werden. Sie wird gebildet, indem das Integral der Momentan-Spannungs-Kurve 305 vom aktuellen Ladezustand bis zu einem minimalen Ladezustand gebildet wird und anschließend wieder durch den aktuellen Ladezustand dividiert wird. Das Ergebnis entspricht der im Mittel während der verbleibenden Entladung der Batterie anliegenden Spannung, so dass sich durch Multiplikation des derzeitigen Ladungswertes sehr einfach die nutzbare Energie abschätzen lässt.

Zur Ermittlung der verbleibenden Energie aus der Ladungsmenge wird bevorzugt die Effektiv-Spannungs-Kurve 304 verwendet und lediglich als Alternative die Momentan-Spannungs-Kurve 305, welche zu Vergleichszwecken in Fig. 2a eingezeichnet ist.

Beide Kurven 304, 305 werden bei Entladung einer Batterie 106, insbesondere einer HV-Batterie 106, von dem rechts liegenden 100%-SOC-Wert zu dem links liegenden 0%-SOC-Wert durchlaufen. Bei der Entladung wird bevorzugt zu jedem Zeitpunkt die verbleibende Ladung in Ah (Ampere-Stunden) mit der im Mittel während der Entladung vorhergesagten Spannung 304 multipliziert und nicht mit der derzeitigen Momentan-Spannung 305. Es ist am Verlauf der beiden Kurven 304 und 305 zu erkennen, dass die Effektiv-Spannungs-Kurve 304 linearer verläuft als die Momentan-Spannungs-Kurve 305, wodurch sich stabilere Vorhersage Werte erreichen lassen.

Die dargestellte Effektiv-Spannungs-Kurve 304 gilt für eine betriebswarme Batterie 106, da zumindest bei einem hohen Ladezustand davon auszugehen ist, dass sich die Batterie bis zum Erreichen eines kritischen Zustands entsprechend aufheizen wird. Als kritischer Zustand mag der entladene Ladezustand "leer" bei 0% SOC bzw. ein nahezu entladener Ladezustand bei 5% SOC angesehen werden.

In einer alternativen Ausführungsform ist es möglich, mit der Energieschätzeinrichtung 104 die Temperatur des Energiespeichers 106 und/oder den Innenwiderstand des Energiespeichers 106 vorherzusagen. Mittels der vorhergesagten Temperatur und/oder dem Innenwiderstand wird dann die äußere Spannung 302 der Batterie 106, welche durch die Momentan-Spannungs-Kurve 305 angegeben ist, um die zu jedem Zeitpunkt zu erwartende Temperatur korrigiert und dann die verbleibende Entladung 301 bestimmt. Die Batterie 106 mag beispielsweise als Batterie-Pack 106 ausgeführt sein.

Zur Bestimmung der Ladung wird sowohl bei Verwendung der Effektiv-Spannungs-Kurve 304 als auch in der alternativen Ausführungsform bei Verwendung der Momentan-Spannungs-Kurve 305 mit Temperaturkorrektur, die jeweilige Kurve 304, 305 von dem 0% Wert bis zu dem aktuellen Ladezustandswert 301 integriert.

Es ist der Fig. 2a auch zu entnehmen, dass die SoC- Werte 301 der Spannungs - Ladezustands-Kurven 304, 305 in dem Betriebsbereich 303 oder dem maximal genutzten SOC Bereich 303 liegen, welcher von ca. 5% bis 98% SOC reicht. Damit können Abschaltmechanismen des BMS 103 realisiert werden, die beispielsweise eine vollständige Entladung und/oder Tiefentladung des Energiespeichers 106 verhindern können. Auf einer Anzeigeeinrichtung 108b kann dieser Bereich von 5% bis 98% auf 0% bis 100% beispielsweise mittels der Reichweitenschätzeinrichtung 108 skaliert werden, so dass ein Nutzer den Eindruck erhält den vollen Batteriebereich auszuschöpfen, obwohl er lediglich einen Bereich von 5% bis 98% der physikalischen Ladung nutzt. Zur Verhinderung einer Tiefentladung würde das BMS 103 die Batterie 106 bereits bei 5% abschalten, bevor die physikalische 0% Entladung erreicht wird.

Die Fig. 2b zeigt zwei Energie-Reichweiten-Kurven 402 in einem Energie-Reichweiten-Diagramm 400 gemäß einem exemplarischen Ausführungsbeispiel der vorliegenden Erfindung.

In dem Diagramm 400 sind auf der Abszisse 404 die Rest-Reichweite oder Fahrstrecke im Bereich -60 km bis 0 km und von 0 km bis 60km eingetragen. Auf der Ordinate 205 sind Energiewerte bzw. der Energieinhalt der Batterie im Bereich von 0 kWh bis 30 kWh eingetragen.

Die Energie-Reichweiten-Kurve 401 zeigt eine Energie-Reichweiten-Kurve ohne Berücksichtigung der Strom-Parameter. In dieser erfolgt die Temperaturmessung zu Beginn des Fahrtzyklus, weshalb die Kurve 401 zu Beginn nahezu stagniert. Dieses Verhalten ist vergleichbar unplausibel, wie der Anstieg der Energie-Reichweiten-Kurve 202 zu Beginn des Fahrtzyklus. Es ist auch zu erkennen, dass bei einer Fahrtstrecke über 10 km zwar Energie verbraucht wird, dass aber auch gleichzeitig durch Erwärmung das Rechenmodell "wächst", so dass die Kurve allzu flach verläuft. Im Extremfall kann die Energie-Reichweiten-Kurve 401 sogar steigen, ähnlich wie die Energie-Reichweiten-Kurve 202.

Die Energie-Reichweiten-Kurve 402 zeigt wiederum zwei Kurvenabschnitte 402a und 402b', 402b'', 402b‴ sowie 402b und 402b', 402b", 402b‴. Hierbei werden zwei Varianten 402a, 402c von ersten Kurvenabschnitten gezeigt.

Der erste Kurvenabschnitt 402a der Energie-Reichweiten-Kurve 402 zeigt eine erste Variante eines ersten Kurvenabschnitts 402a einer Energie-Reichweiten-Kurve 402 bei der ein Ladungsmodell genutzt wird.

Der erste Kurvenabschnitt 402c der Energie-Reichweiten-Kurve 402 zeigt eine zweite Variante einer Energie-Reichweiten-Kurve 402, bei der ein Energieintegral verwendet wird.

Sowohl die erste Variante 402a als auch die zweite Variante 402c wurde unter Berücksichtigung der Strom-Parameter korrigiert.

Die Kurve 403 ist eine Vergleichskurve, welche einen linearen Verlauf einer Energie-Reichweiten-Kurve zeigt.

Bei beiden Varianten der Energie-Reichweiten-Kurven 402a, 402c wird bei Kilometer Null auf der Abszisse 404 das Ziel an einer Ladestation erreicht. Dabei ergibt sich der kleine Versatz zwischen den Kurven 402a, 402b, da bereits wieder geladen wurde. Es wird hierbei jedoch auch darauf geachtet, dass ein stetiger und im Wesentlichen versatzfreier Verlauf gebildet wird, auch wenn in der Darstellung ein leichter Versatz zu erkennen ist.

Die Kurven 402a, 402b werden jeweils stetig von der Maximal-Reichweiten-Kurve 402b', der Reichweitenvorhersage-Kurve 402b'' und der Minimal-Reichweiten-Kurve 402b‴ fortgesetzt, welche entsprechend der Maximal-Reichweiten-Kurve 202b', der Reichweitenvorhersage-Kurve 202b'' und der Minimal-Reichweiten-Kurve 202b‴ eine Vorhersage über die Reichweite treffen.

Sämtliche bei Fig. 2 getroffenen Feststellungen mögen entsprechend für Fig. 2b gelten, insbesondere die Beschreibung der Komponenten der Energiemanagementvorrichtung 100.

Es sei jedoch angemerkt, dass der Ladestopp bei der in Fig. 2b dargestellten Fahrt etwa 60 km vor dem Erreichen der vollständigen Entladung geplant war und sich somit noch eine weitere Restreichweite ergibt. Es zeigt sich jedoch insbesondere im Beispiel der Fig. 2, dass die Vorhersage im Wesentlichen so genau getroffen werden kann, dass sich durch Anpassung der Fahrweise, die durch die gestrichelten Linien 202b', 202b", 202b‴ bzw. 402b', 402b'', 402b‴ dargestellt ist, die Reichweite notfalls bis zum Ziel ausdehnen lässt.

In Fig. 2b ist ferner eine Summenkurve 406 aus dicken Punkten dargestellt, welche die Summe aus Fahrstrecke und Restreichweite zeigt. Die Summenkurve 406 wird als Summe aus der bereits zurückgelegten Fahrstrecke, im Beispiel seit km -65 oder der ausgehend von -65km zurückgelegten Fahrtstrecke, und der verbleibenden Restreichweite gebildet. Aufgetragen ist dies über den y-Werten 405 des aktuellen Energiegehalts in kWh. Dabei wird das Rechenergebnis transformiert und in x-Richtung 404 statt in y-Richtung 405 eingetragen. Das Rechenergebnis ist in x statt wie üblich in y eingetragen.

Der nahezu vertikale Verlauf der Summenkurve 406, der sich einer vertikalen Linie eines im Wesentlichen perfekten Vorhersage-Verlaufs annähert, zeigt wie gut mittels der Berücksichtigung der Strom-Parameter eine Reichweitenvorhersage getroffen werden kann.

Da die mittels der Summenkurve 406 dargestellte Vorhersage etwas abnimmt und die Verbrauchskurven steiler werden, ist zu erkennen, dass in dem in Fig. 2b dargestellten Beispiel kurz vor Erreichen der Ladestation bei dem Fahrtstrecken-Wert 404 von etwa 0km schneller gefahren wurde.

Mittels weiterer Strom- bzw. Temperaturabhängigkeits-Kurven können weitere Korrekturen in die Kurven 402a, 402b mit eingerechnet werden, wobei der erwartete Verlauf berücksichtigt wird. Durch diese Berücksichtigung von Vorhersage-Werten kann die Verbesserung gegenüber den Kurven 202 und 401 erreicht werden, bei denen die Korrektur lediglich aus aktuellen Messwerten und nicht aus Vorhersagewerten vorgenommen wird.

Die von dem BMS 103 oder der Energiespeicher-Verwaltungseinrichtung 103 ermittelten Energiespeicher-Parameter werden bereits vor kompensiert und über die Schnittstelle 105, an die Energieschätzeinrichtung 104 weitergereicht, welche eine weitere Vorhersage der Energiewerte der Batterie 106 vornimmt, indem sie beispielsweise im Wesentlichen nur Strom-Parameter verarbeitet.

Die Reichweitenschätzeinrichtung 108 ist als nachfolgendes Steuersystem der Energiespeicher-Verwaltungseinrichtung 103 ausgebildet und weist einen Reichweiten-Schätz-Algorithmus und /oder ein Verfahren auf, welcher/welches als Subroutine des gesamten Steuerverfahrens ausgebildet sein kann und die verfügbare Energie in der Form von Strom basierten Energie-Werten aufnimmt.

Die Reichweitenschätzeinrichtung 108 berücksichtigt auch noch Verbrauchswerte von zusätzlichen Verbrauchern. Diese Verbrauchswerte können mit äußeren Sensoren gemessen werden, Voraussagen für die Zukunft können jedoch auch nur geschätzt werden. Zusätzliche Verbraucher liefern ihren Energiebedarf oft in der Einheit kW. Dieser Energiebedarf kann aber mit Daten des Gesamtfahrzeugs, wie beispielsweise die aktuelle Geschwindigkeit oder die Vorhersage der Geschwindigkeit aus dem Routenplaner einfach in die Einheit kWh/100km umgerechnet und dem Energiebedarf für das Fahren zugeschlagen werden.

Die Reichweitenschätzeinrichtung 108 führt somit die strombasierten Werte der verfügbaren Energie und/oder die Ladung der Batterie 106 und die zu erwartenden Verbrauchswerte zusammen, um eine Rest-Reichweite zu ermitteln. Dabei mag die Reichweitenschätzeinrichtung 108 auch die Verbrauchswerte auf Strombasis berechnen und/oder in Strom-Parameter basierte Werte wandeln, um eine gemeinsame Basis zur Verrechnung mit den Strom basierten Energiewerten zu haben. Dadurch mag eine Unabhängigkeit von der schwer und nur instabil zu bestimmenden Spannung geschaffen werden.

Die von der Reichweitenschätzeinrichtung 108 ermittelten Werte der Reichweitenvorhersage und/oder die Rest-Reichweite können/kann über die Anzeigeeinrichtung 108b einem Nutzer des Transportmittels angezeigt werden, insbesondere dem Fahrer des BEV. Die Anzeigeeinrichtung 108b kann als ein Mensch-Maschine-Interface (HMI, Human Machine Interface), insbesondere als Bildschirm, ausgebildet sein. Alternativ oder zusätzlich kann die Anzeigeeinrichtung 108b auch mit einem Koordinations-Controller (Coordination Controller) verbunden sein, in dem dann weitere Schätzungen durchgeführt werden können und/oder Verkehrsdaten gesammelt und abgerufen werden können.

Dadurch, dass die Energiespeicher-Verwaltungseinrichtung 103 oder das BMS 103 Zugriff auf eine Datenbank hat, kann das BMS 103 auch eine a priori bekannte Charakteristik des Energiespeichers 106 oder eine a priori bekannte Charakteristik der Batterie 106 berücksichtigen, um die geringere Spannung einer fast leeren Batterie 106 zu kompensieren.

Auf ähnliche Weise kann das BMS 103 auch äußere Parameter mit Fühlern und/oder Sensoren erfassen und den momentanen Strom in Verbindung mit einer Umgebungsbedingung nutzen, um die Temperatur des Energiespeichers 106 und/oder den Innenwiderstand des Energiespeichers 106 vorherzusagen. Da die verfügbare Energie einer Batterie 106 von der Batteriespannung abhängt, die wiederum von dem momentanen Strom durch die Batterie 106 und dem Innenwiderstand der Batterie 106 abhängen mag, sind Strom und Temperatur Einflussfaktoren für die in der Batterie 106 vorhandene Energie. Hierbei mag vorteilhaft sein, dass sich die Temperatur der Batterie 106 sehr langsam ändert.

Alternativ oder zusätzlich kann die Ladezustandserfassungseinrichtung 103 oder das BMS 103 eingerichtet sein, eine Filterung der SoE-Werte durchzuführen und beispielsweise einen über längeren Zeitraum konstanten Mittelwert erzeugen. Denn der Momentan-Strom durch die Batterie 106 mag sich während des Fahrens schnell ändern, wodurch es gerade im Bereich einer leeren Batterie kommen kann, falls Momentan-Werte genutzt werden.

Jedoch mag insgesamt bei der Konzeption der Energiemanagementvorrichtung 100 vorgesehen sein, die Energiespeicher-Verwaltungseinrichtung 103 mit möglichst wenig Rechenleistung auszustatten und im Wesentlichen lediglich als Lieferant der Vielzahl an Parametern zu nutzen.

Die meisten Korrekturen und/oder Kompensationen werden in der Energieschätzeinrichtung 104 durchgeführt, welche mit einer ausreichenden Rechenleistung ausgestattet ist und unter Umständen den Prozessor 102 nutzen kann. Die Energieschätzeinrichtung 104 hat auch Zugriff zu einem Fahrzeugmodell.

Da die Batterietemperatur einen Einfluss auf den Innenwiderstand der Batterie 106 hat und der Innenwiderstand über die Spannung einen Einfluss auf die in der Batterie verfügbaren Energie hat, mag die Vorhersage der Zelltemperatur einzelner Zellen der Batterie 106 hilfreich bei der Reichweitenabschätzung sein.

Denn der Batteriestrom kann in Kombination mit äußeren Parametern und/oder Umgebungsbedingungen, wie beispielsweise der Außentemperatur, und weiterer bekannter Kenngrößen, wie beispielsweise das Verhalten des Batteriekühlsystems, genutzt werden, die Zelltemperatur der Batterie 106 und den Innenwiderstand der Batterie 106 vorherzusagen.

Es mag also in einem Ausführungsbeispiel der vorliegenden Erfindung die Reichweitenschätzeinrichtung 108 so angepasst sein, mittels der Fühler und/oder Sensoren des BMS 103 und anderer Voraussagewerte und/oder historischer Daten, einen spezifischen Verbrauch zu ermitteln und so den am wahrscheinlichsten vorhandenen Batteriestrom zu berechnen. Dieser berechnete zu erwartende Verbrauchsstrom kann dann dazu genutzt werden, den für den Rest der Fahrt zu erwartenden Leistungs- und/oder Energieverbrauch abzuschätzen. Aus dem ermittelten stabilen Restenergiewert der Batterie 106 und dem abgeschätzten zukünftigen Verbrauchswert kann eine stabile Vorhersage für die zu erwartende Reichweite gemacht werden. Diese Vorhersage soll möglichst stabil bleiben bis das Ziel erreicht wird. Bedingungen die zu einem Anstieg des Energieverbrauchsführen könnten, wie starke Steigungen können beispielsweise dadurch berücksichtigt werden, dass Daten aus Verkehrsinformationsund/oder Navigationssystemen mit in die Reichweiten Berechnung einfließen. Ebenso mag ein Fahrprofil oder Fahrerprofil berücksichtigt werden, beispielsweise sportlich, aggressiv oder defensiv.

Die Fig. 3 zeigt ein Flussdiagramm für ein Verfahren zum Bereitstellen eines Energie-Zustandswertes eines Energiespeichers 106 gemäß einem exemplarischen Ausführungsbeispiel der vorliegenden Erfindung.

Ausgehend von einem Startzustand S300 werden im Zustand S301 einer Vielzahl in dem Energiespeicher 106 vorhandene Energiespeicher-Parameter erfasst, beispielsweise indem die Energiespeicher-Verwaltungseinrichtung 103 mittels Sensoren spezifische Standard Parameter misst, wie den Entlade- und/oder Ladestrom und/oder eine Zellspannung; außerdem erfolgt ein Bereitstellen der Vielzahl erfasster oder in dem Energiespeicher 106 vorhandener Energiespeicher-Parameter.

Im Zustand S302 sieht die Operation S302 ein Auswählen von im Wesentlichen nur Strom-Parametern vor, wobei ein Strom-Parameter ein Parameter ist, der auf den Stromfluss in und/oder aus dem Energiespeicher 106 einen Einfluss hat. In anderen Worten werden Strom-Parameter bei der Auswahl bevorzugt und/oder herausgefiltert.

Im Zustand S303 erfolgt das Empfangen der Vielzahl von Energiespeicher-Parameter, insbesondere der Auswahl an Strom-Parametern. Die Auswahl und das Empfangen kann beispielsweise in der Energieschätzeinrichtung 104 erfolgen.

Im Zustand S304 wird ein Energie-Schätzwerte aus der Vielzahl von Energiespeicher-Parametern; insbesondere aus den Strom-Parametern, ermittelt und bereitgestellt, um den Energie-Schätzwert beispielsweise an eine Reichweitenschätzeinrichtung 108 weiterzugeben.

Im Zustand S305 endet das Verfahren.

Obwohl die Erfindung im Detail durch bevorzugte Ausführungsbeispiele näher illustriert und erläutert wurde, so ist die Erfindung nicht durch die offenbarten Beispiele eingeschränkt und andere Variationen können vom Fachmann hieraus abgeleitet werden, ohne den Schutzumfang der Erfindung zu verlassen. Es ist daher klar, dass eine Vielzahl von Variationsmöglichkeiten existiert. Es ist ebenfalls klar, dass beispielhaft genannte Ausführungsformen wirklich nur Beispiele darstellen.

### Bezugszeichenliste

- 100: Energiemanagementvorrichtung
- 101: Modulgehäuse
- 102: Prozessor
- 103: Energiespeicher-Verwaltungseinrichtung (BMS)
- 104: Energieschätzeinrichtung
- 105: Schnittstelle zum Bereitstellen von Energiespeicher-Parametern
- 106: Energiespeicher
- 107: Datenbank
- 108: Reichweitenschätzeinrichtung
- 108a: Schnittstelle für Energieschätzwert
- 108b: Anzeigeeinrichtung

- 200: Energie-Reichweiten-Diagramm
- 202: Energie-Reichweiten-Kurve
- 202a: erster Kurvenabschnitt der Energie-Reichweiten-Kurve
- 202b': Maximal-Reichweiten-Kurve
- 202b'': Reichweitenvorhersage-Kurve
- 202b‴: Minimal-Reichweiten-Kurve

- 204: Abszisse
- 205: Ordinate

- 300: Spannungs-Ladezustands-Diagramm
- 301: Abszisse
- 302: Ordinate
- 303: Betriebsbereich
- 304: Effektiv-Spannungs-Kurve
- 305: Momentan-Spannungs-Kurve
- 400: Energie-Reichweiten-Diagramm
- 401: Energie-Reichweiten-Kurve ohne Berücksichtigung von Strom-Parametern
- 402: Energie-Reichweiten-Kurve mit Berücksichtigung von Strom-Parametern
- 402a, 402c: erster Kurvenabschnitt einer Energie-Reichweiten-Kurve
- 402b': Maximal-Reichweiten-Kurve
- 402b": Reichweitenvorhersage-Kurve
- 402b‴: Minimal-Reichweiten-Kurve
- 403: Vergleichskurve
- 404: Abszisse
- 405: Ordinate
- 406: Summenkurve

- S300... S305: Verfahrensschritte

- 402b": Reichweitenvorhersage-Kurve
- 402b‴: Minimal-Reichweiten-Kurve
- 403: Vergleichskurve
- 404: Abszisse
- 405: Ordinate
- 406: Summenkurve

- S300 ... S305: Verfahrensschritte

## Patentansprüche

1. Energiemanagementvorrichtung (100) für einen Energiespeicher (106), aufweisend
- einen Energiespeicher (106);
- eine Energiespeicher-Verwaltungseinrichtung (103);
- eine Energieschätzeinrichtung (104) sowie
- eine Reichweitenschätzeinrichtung (108);
wobei die Energiespeicher-Verwaltungseinrichtung (103) zum Erfassen und Bereitstellen von einer Vielzahl in dem Energiespeicher (106) vorhandenen Energiespeicher-Parametern eingerichtet ist;
wobei die Energieschätzeinrichtung (104) zum Empfangen der Vielzahl von Energiespeicher-Parameter und zum Bereitstellen eines Energie-Schätzwertes aus der Vielzahl von Energiespeicher-Parametern eingerichtet ist;
wobei die Energieschätzeinrichtung (104) aus der bereitgestellten Vielzahl von Energiespeicher-Parametern im Wesentlichen nur Strom-Parameter auswählt;
wobei ein Strom-Parameter ein Parameter ist, der auf den Stromfluss in und/oder aus dem Energiespeicher (106) einen Einfluss hat;
wobei die Reichweitenschätzeinrichtung (108) eingerichtet ist, den EnergieSchätzwert in eine Schätz-Reichweite (202b', 202b", 202b‴) umzuwandeln und
wobei die Reichweitenschätzeinrichtung (108) zum Umwandeln des Energie-Schätzwertes in die Reichweite eine Energie-Reichweiten-Kurve (202) nutzt, welche in Strom-Parametern dargestellt ist;
**dadurch gekennzeichnet, dass** die Energie-Reichweiten-Kurve (202) einen ersten (202a) und einen zweiten (202b) Kurvenabschnitt aufweist;
wobei der zweite Kurvenabschnitt (202b) der Energie-Reichweiten-Kurve (202), welcher im Bereich einer niedrigen vorhandenen Energie im Energiespeicher (106) liegt; mit einer höheren Genauigkeit ermittelt worden ist, als der erste Kurvenabschnitt (202a) der Energie-Reichweiten-Kurve (202), welcher im Bereich einer hohen vorhandenen Energie im Energiespeicher (106) liegt; und
wobei der erste Kurvenabschnitt (202a) so an den zweiten Kurvenabschnitt (202b) angepasst ist, dass die Energie-Reichweiten-Kurve (202) eine stetige Kurve (202) bildet.

2. Energiemanagementvorrichtung (100) nach Anspruch 1, wobei der Strom-Parameter zumindest ein Energiespeicher-Parameter ist, ausgewählt aus der Gruppe der Energiespeicher-Parameter, bestehend aus:
- Strombilanzwert;
- elektrischer Widerstand des Energiespeichers (106);
- Momentan-Spannung am Energiespeicher (106);
- Momentan-Strom am Energiespeicher (106);
- Energiespeicher-Temperatur;
- Alter des Energiespeichers (106); und
- Inter-Zellspannungsdifferenz einzelner Zellen des Energiespeichers (106).

3. Energiemanagementvorrichtung (100) nach Anspruch 1 oder 2, wobei ein Übergang von dem ersten Kurvenabschnitt (202a) zu dem zweiten Kurvenabschnitt (202b) der Energie-Reichweiten-Kurve (202) von zumindest einem Übergangskriterium abhängt, ausgewählt aus der Gruppe von Übergangskriterien, bestehend aus:
einer Betriebszeit;
einem Ladezustand des Energiespeichers (106);
einer Mindestdistanz zu einem Ziel; und
einem Trigger-Ereignis.

4. Energiemanagementvorrichtung (100) nach einem der Ansprüche 1 bis 3, wobei die Energieschätzeinrichtung (104) eingerichtet ist, die Temperatur des Energiespeichers (106) und/oder den Innenwiderstand des Energiespeichers (106) vorherzusagen.

5. Energiemanagementvorrichtung (100) nach einem der Ansprüche 1 bis 4, weiter aufweisend:
- eine Anzeigeneinrichtung (108b);
wobei die Anzeigeneinrichtung (108b) zum Anzeigen der Schätz-Reichweite eingerichtet ist.

6. Verfahren zum Bereitstellen eines Energie-Schätzwertes eines Energiespeichers, aufweisend:
- Erfassen von einer Vielzahl in dem Energiespeicher (106) vorhandenen Energiespeicher-Parametern;
- Bereitstellen der Vielzahl von erfassten in dem Energiespeicher (106) vorhandenen Energiespeicher-Parametern;
- Empfangen der Vielzahl von Energiespeicher-Parameter;
- Bereitstellen eines Energie-Schätzwertes aus der Vielzahl von Energiespeicher-Parametern; wobei für das Bereitstellen des Energie-Schätzwertes im Wesentlichen nur Strom-Parametern ausgewählt werden, und wobei ein Strom-Parameter ein Parameter ist, der auf den Stromfluss in und/oder aus dem Energiespeicher (106) einen Einfluss hat;
- Umwandeln des Energie-Schätzwertes in eine Schätz-Reichweite; wobei zum Umwandeln des Energie-Schätzwertes in die Reichweite eine Energie-Reichweiten-Kurve (202) genutzt, welche in Strom-Parametern dargestellt ist;
**dadurch gekennzeichnet, dass**, die Energie-Reichweiten-Kurve (202) einen ersten (202a) und einen zweiten (202b) Kurvenabschnitt aufweist;
wobei der zweite Kurvenabschnitt (202b) der Energie-Reichweiten-Kurve (202), welcher im Bereich einer niedrigen vorhandenen Energie im Energiespeicher (106) liegt; mit einer höheren Genauigkeit ermittelt worden ist, als der erste Kurvenabschnitt (202a) der Energie-Reichweiten-Kurve (202), welcher im Bereich einer hohen vorhandenen Energie im Energiespeicher (106) liegt; und
wobei der erste Kurvenabschnitt (202a) so an den zweiten Kurvenabschnitt (202b) angepasst ist, dass die Energie-Reichweiten-Kurve (202) eine stetige Kurve (202) bildet.

7. Transportmittel mit einer Energiemanagementvorrichtung (100) nach einem der Ansprüche 1 bis 5.

## Claims

1. Energy management device (100) for a Energy storage device (106), comprising
- a energy storage (106);
- one Energy storage management device (103);
- one Energy estimation device (104) and
- one range estimation device (108);
wherein the energy storage management device (103) is Capture and Providing a variety in the energy storage (106) available energy storage parameters furnished is
wherein the energy estimation device (104) for Receiving the multitude of energy storage parameters and for the Provide an energy estimate from the multitude of energy storage parameters furnished is ;
wherein the energy estimation device (104) from the provided variety of energy storage parameters in the essential only selects current parameters ;
where a current parameter is a parameter that affects the current flow in and/ or from the energy storage device (106) a Influence has;
wherein the range estimation device (108) is arranged is to convert the energy estimate into a Estimated range (202b', 202b", 202b‴) and
wherein the range estimation device (108) for Converting the energy estimate into the range one Energy-range curve (202) which is expressed in current parameters shown is ;
through this **characterized in that** the energy -range curve (202) has a first (202a) and one second (202b) curve section has ;
where the second Curve section (202b) of the energy-range curve (202), which in the Area one low existing energy in the Energy storage device (106) is located ; with one higher accuracy determined been is when the first Curve section (202a) of the energy-range curve (202), which in the Area one high existing energy in the energy storage device (106) is located ; and
where the first Curve section (202a) to the second curve section (202b) adjusted is that the energy-range curve (202) is a continuous Curve (202) forms .

2. Energy management device (100) according to Claim 1, wherein the current parameter at least a energy storage parameters is selected from the group of Energy storage parameters, consisting out of :
- electricity balance value ;
- electric Resistance of the energy storage device (106);
- instantaneous voltage on energy storage (106);
- instantaneous current on energy storage (106);
- energy storage temperature ;
- Age of the energy storage (106) and
- inter- cell voltage difference individual Cells of the energy storage (106).

3. Energy management device (100) according to Claim 1 or 2, wherein a transition from the first Curve section (202a) to the second Curve section (202b) of the Energy-range curve (202) of at least one transition criterion depends on selected from the group of transition criteria consisting out of :
one operating time ;
one state of charge of the energy storage device (106);
one minimum distance to one target ; and
a trigger event .

4. Energy management device (100) according to one of claims 1 to 3, wherein the Energy estimation facility (104) established is to predict the temperature of the energy storage device (106) and / or the internal resistance of the energy storage device (106) .

5. Energy management device (100) according to one of claims 1 to 4, further having :
- one display device (108b);
wherein the display device (108b) is Display the estimated range furnished is .

6. Proceedings for the Provide an energy estimate one energy storage device , comprising :
- Capturing a variety in the energy storage (106) available energy storage parameters ;
- Providing the multitude of recorded in the energy storage (106) available energy storage parameters ;
- Receiving the plurality of energy storage parameters ;
- Provide an energy estimate from the multitude of energy storage parameters ; where for the Providing the energy estimate in the essential only current parameters selected become , and where a current parameters a parameter which is directed to the flow of current in and / or out of dem energy storage device (106) Influence has ;
- Converting the energy estimate into a estimated range ; where for the Converting the energy estimate into the range an energy range curve (202) is used , which in current parameters shown is ;
through this **characterized in that** the energy range curve (202) has a first (202a) and a second (202b) curve section has ;
where the second Curve section ( 202b) of the energy range curve (202), which in the Area one low available energy in the Energy storage device (106) is located ; with a higher accuracy determined been is , as the first Curve section ( 202a ) of the energy range curve (202), which in the Area one high available energy in the energy storage device (106) is located ; and
where the first Curve section (202a) to the second curve section (202b) adjusted is that the energy-range curve (202) is a continuous Curve (202) forms .

7. Means of transport with a Energy management device (100) according to one of claims 1 to 5.

## Revendications

1. Dispositif de gestion d'énergie (100) pour un Stockage d'énergie (106), comprenant
- un stockage d'énergie (106) ;
- un dispositif de gestion de stockage d'énergie (103) ;
- un Dispositif d'estimation d'énergie (104) et
- un un dispositif d'estimation de distance (108) ;
dans lequel le dispositif de gestion de stockage d'énergie (103) pour capturer et en fournir un variété dans ce domaine stockage d'énergie (106) présent paramètres de stockage d'énergie meublé est ;
dans lequel le dispositif d'estimation d'énergie (104) pour recevoir la variété de paramètres de stockage d'énergie et pour le fournir un devis énergétique de la variété des paramètres de stockage d'énergie meublé est ;
dans lequel le dispositif d'estimation d'énergie (104) provient de celui fourni Variété de paramètres de stockage d'énergie dans le essentiellement sélectionne uniquement les paramètres actuels ;
où Un paramètre de courant est un paramètre qui affecte le flux de courant entrant et/ ou du stockage d'énergie ( 106) Influence a ;
dans lequel le dispositif d'estimation de distance (108) est configuré c'est-à -dire l'estimation de l'énergie en une seule Plage d'estimation (202b', 202b", 202b‴) et
dans lequel le dispositif d'estimation de distance (108) pour Conversion de l'estimation d'énergie en plage un La courbe de plage d'énergie (202) utilise laquelle dans les paramètres actuels montré est ;
à travers ça **caractérisé en ce que** la courbe de plage d'énergie (202) présente un premier (202a) et un deuxième (202b) section de courbe a ;
où le deuxième Section de courbe (202b) de la courbe de plage d'énergie (202), qui dans le Zone un faible existant énergie dans le stockage d'énergie (106) est situé ; avec un plus haut précision déterminé a été est , comme le premier Section de courbe (202a) de la courbe de plage d'énergie (202), qui dans le Zone un haut existant énergie dans le Le stockage d'énergie (106) est situé ; et
où le premier Section courbe (202a) vers la seconde Section de courbe (202b) adaptée est que la courbe de plage d'énergie (202) est une constant La courbe (202) se forme .

2. Dispositif de gestion d'énergie (100) revendication 1, dans laquelle le paramètre actuel au moins un paramètres de stockage d'énergie est sélectionné du groupe de paramètres de stockage d'énergie , comprenant sur :
- Valeur du bilan électrique ;
- résistance électrique du stockage d'énergie (106) ;
- Tension instantanée sur stockage d'énergie (106);
- Courant instantané sur stockage d'énergie (106);
- température de stockage d'énergie ;
- Âge du stockage d'énergie (106); et
- Différence de tension intercellulaire individuel Cellules de stockage d'énergie (106).

3. Dispositif de gestion d'énergie (100) . Revendication 1 ou 2, dans laquelle un transition
dès le premier Section courbe (202a) à la seconde Section de courbe (202b) la Courbe de plage d'énergie (202) d'au moins un Critère de transition ça dépend , choisi du groupe des critères de transition sur :
un temps de fonctionnement ;
un État de charge du stockage d'énergie (106) ;
un Distance minimale à un But ; et
un événement déclencheur .

4. Dispositif de gestion d'énergie (100) . l'une des revendications 1 à 3, dans laquelle le Dispositif d'estimation d'énergie (104) mis en place consiste à prédire la température du stockage d'énergie (106) et / ou la résistance interne du stockage d'énergie (106) .

5. Dispositif de gestion d'énergie (100) . I'une des revendications 1 à 4, en outre ayant :
- un dispositif d'affichage (108b) ;
dans lequel le dispositif d'affichage (108b) pour Afficher la plage estimée meublé est .

6. Procédure pour le Fournir une valeur énergétique estimée un Stockage d'énergie , comprenant :
- En capturer un Variété dans ce domaine Stockage d'énergie (106) présent paramètres de stockage d'énergie ;
- Offrant la variété des éléments capturés dans le Stockage d'énergie (106) présent paramètres de stockage d'énergie ;
- Recevoir la variété des paramètres de stockage d'énergie ;
- Fournir un devis énergétique de la variété des paramètres de stockage d'énergie ; où pour le Fournir le devis énergétique dans le Essentiellement seulement Paramètres actuels choisi devenir et où un Paramètres actuels un paramètre est qui fait référence au flux de courant entrant et / ou de ils Stockage d'énergie (106) . Influence a ;
- Conversion de l'estimation énergétique en portée estimée ; où pour le Conversion de l'estimation d'énergie en plage une courbe de plage d'énergie (202) est utilisée , qui est dans les paramètres actuels montré est ;
à travers ça **caractérisé en ce que** la courbe de plage d'énergie ( 202) est une premier (202a) et un deuxième (202b) section de courbe a ;
où le deuxième Section de courbe ( 202b) de la courbe de plage d'énergie (202), qui dans le Zone un faible l'énergie existante dans Le stockage d'énergie (106) est situé ; avec un plus haut précision déterminé a été est , comme le premier Section de courbe ( 202a ) de la courbe de plage d'énergie (202), qui dans le Zone un haut l'énergie existante dans Le stockage d'énergie (106) est situé ; et
où le premier Section courbe (202a) vers la seconde Section de courbe (202b) adaptée est que la courbe de plage d'énergie (202) est une constant La courbe (202) se forme .

7. Moyen de transport avec un Dispositif de gestion d'énergie (100) l'une des revendications 1 à 5.
